# FASCICULE DE BREVET EUROPEEN

(11) **EP 4 246 570 B1**
(45) Date de publication et mention de la délivrance du brevet: **10.12.2025**
(21) Numéro de dépôt: 23162343.0
(22) Date de dépôt: 16.03.2023
(51) Int. Cl.: H01L 23/427, H01L 23/047, H01L 23/473, H01L 23/04, H01L 23/057

(54) **BOÎTIER POUR ENCAPSULATION DE COMPOSANT(S) ÉLECTRONIQUE(S) ET ASSEMBLAGE ÉLECTRONIQUE ASSOCIÉ**
GEHÄUSE ZUR VERKAPSELUNG ELEKTRONISCHER KOMPONENTEN UND ELEKTRONISCHE BAUGRUPPE DAFÜR
HOUSING FOR ENCAPSULATING ELECTRONIC COMPONENT(S) AND ASSOCIATED ELECTRONIC ASSEMBLY

(30) Priorité: 17.03.2022 FR 2202355
(43) Date de publication de la demande: 20.09.2023
(73) Titulaire: THALES, 92400 Courbevoie (FR)
(72) Inventeur: KERTESZ, Philippe, 78851 ELANCOURT CEDEX (FR); RODRIGUES, Pedro, 78851 ELANCOURT CEDEX (FR); VOUZELAUD, Franck, 78851 ELANCOURT CEDEX (FR)
(74) Mandataire: Lavoix

(56) Documents cités:
- DE-A1- 102010 041 714
- US-A1- 2003 019 234

## Description

La présente invention concerne un boîtier pour encapsulation de composant(s) électronique(s), de préférence, et un assemblage électronique associé.

L'invention se situe dans le domaine des composants micro-électroniques, et plus spécifiquement dans le domaine de l'encapsulation (ou « packaging ») de tels composants.

L'encapsulation de composants électroniques, en particulier à base de semi-conducteurs, appelés plus simplement composants semi-conducteurs, est généralement réalisée dans des matériaux homogènes (métal, céramique, plastique), un ou plusieurs tels composants étant encapsulés dans un contenant ou boîtier, réalisé dans un matériau homogène, qui comporte une ou plusieurs connexions reliant l'intérieur du boîtier avec l'extérieur, afin de réaliser la connexion du ou des composants semi-conducteurs dans un circuit. L'encapsulation regroupe les fonctions d'isolation, de connexion, de gestion thermique et de protection physique du ou des composants semi-conducteurs.

Le fonctionnement électrique des composants semi-conducteurs s'accompagne d'un échauffement lié à leur rendement électrique ou à la puissance dissipée. En particulier dans le domaine de la micro-électronique hyperfréquence, par exemple dans le cas des amplificateurs de puissance hyperfréquence, une forte densité de puissance est produite par les composants, et par conséquent un fort échauffement du ou des composants est constaté.

L'élévation de température affecte la performance du composant semi-conducteur et conduit à des phénomènes de dilatation des matériaux. De plus, l'élévation de température peut accentuer des phénomènes de diffusion métallurgique et/ou électrochimique, ce qui risque d'accélérer le vieillissement ou de réduire la fiabilité du composant semi-conducteur encapsulé. Ces phénomènes de fiabilité sont classiquement modélisés selon la loi d'Arrhénius.

Il existe donc un besoin de dissipation thermique, qui est connu et pris en considération dans le domaine de l'encapsulation des composants semi-conducteurs.

Le document US 2003/019234 A1 décrit un dispositif intégrant un circuit de refroidissement, notamment pour microprocesseur d'ordinateur.

Le document DE 10 2010 041714 A1 décrit un boîtier d'encapsulation de composants électroniques (« semiconductor chips ») avec un dispositif de refroidissement.

Généralement, l'évacuation du flux de chaleur généré par les composants semi-conducteurs est réalisée en reliant thermiquement le ou des composants semi-conducteurs avec des éléments à forte conductivité thermique à l'intérieur du boîtier, le boîtier étant assemblé sur une structure dite « plaque froide » permettant la dissipation thermique. Ainsi, le flux de chaleur généré par le ou les composants semi-conducteurs traverse plusieurs matériaux et interfaces. L'augmentation de température est donc liée à la géométrie de l'assemblage, aux matériaux utilisés et aux interfaces qui créent une résistance thermique additionnelle venant s'opposer au flux de chaleur.

Il est souhaitable de réduire, voire de supprimer, ces résistances thermiques qui réduisent l'efficacité de l'évacuation du flux de chaleur généré par les composants semi-conducteurs.

A cet effet, l'invention propose, selon un aspect, un boîtier pour encapsulation de composant(s) électronique(s), le boîtier formant un réceptacle destiné à recevoir au moins un composant électronique, comportant une première paroi de support dudit au moins un composant électronique, des bords latéraux et une deuxième paroi de fermeture du boîtier, lesdites première et deuxième paroi et lesdits bords latéraux étant réalisés en un premier matériau, et comprenant au moins un organe de connexion électrique s'étendant vers l'extérieur du boîtier, ladite première paroi de support comportant une face intérieure adaptée à recevoir le ou les composants électroniques, et une face extérieure. Ce boîtier comporte un dispositif de refroidissement micro-fluidique dans un deuxième matériau, inséré dans ladite première paroi de support, le dispositif de refroidissement micro-fluidique comportant au moins un canal de circulation d'un fluide caloporteur connecté à un premier orifice d'entrée du fluide caloporteur et à un deuxième orifice de sortie du fluide caloporteur, le dispositif de refroidissement comportant au moins une plateforme de réception du ou des composant(s) électroniques au contact dudit au moins un canal de circulation d'un fluide caloporteur.

Avantageusement, le boîtier proposé comporte un dispositif de refroidissement micro-fluidique dans un deuxième matériau, inséré dans la première paroi de support, ce qui permet de positionner le ou les composants semi-conducteurs en contact direct du dispositif de refroidissement traversé par le fluide caloporteur.

Avantageusement, l'évacuation du flux de chaleur généré par le ou les composant(s) semi-conducteurs est améliorée grâce à ce contact dont la résistance thermique est faible.

Le boîtier pour encapsulation de composant(s) électronique(s), selon l'invention peut également présenter une ou plusieurs des caractéristiques ci-dessous, prises indépendamment ou selon toutes les combinaisons techniquement envisageables.

Le dispositif de refroidissement est fixé à ladite première paroi de support par brasage.

Le deuxième matériau dans lequel est réalisé ledit dispositif de refroidissement est du silicium.

Le boîtier comporte un échangeur thermique dans lequel est formé ledit au moins un canal de circulation d'un fluide caloporteur par micro-usinage.

L'échangeur thermique comporte des ailettes disposées parallèlement, des canaux de circulation d'un fluide caloporteur étant formés entre lesdites ailettes, ou des picots disposés selon un motif régulier, des canaux de circulation d'un fluide caloporteur étant formés entre lesdits picots.

Le premier matériau est un matériau céramique ou métallique ou un matériau composite.

Ladite au moins une plateforme est insérée en saillie sur ladite face intérieure de la première paroi de support, lesdits premier et deuxième orifices s'ouvrant vers ladite face extérieure de la première paroi de support.

La plateforme a des dimensions sensiblement égales aux dimensions d'un composant électronique, ledit composant électronique étant brasé ou collé sur ladite plateforme.

Selon un autre aspect, l'invention concerne un assemblage électronique comportant au moins un boîtier intégrant un dispositif de refroidissement tel que brièvement décrit ci-dessus, et une structure de support intégrant la distribution hydraulique dans le boîtier, le ou chaque boîtier comportant un composant électronique brasé ou collé à l'intérieur du boîtier, en contact avec ledit dispositif de refroidissement.

Selon une variante, la structure de support comporte des canaux de distribution de fluide caloporteur, un desdits canaux de distribution de fluide caloporteur étant connecté aux premiers orifices d'entrée de chaque dispositif de refroidissement et un autre desdits canaux de distribution de fluide caloporteur étant connecté aux deuxièmes orifices de sortie de chaque dispositif de refroidissement, le ou chaque boîtier étant collé par la face extérieure de la première paroi de support à ladite structure de support.

D'autres caractéristiques et avantages de l'invention ressortiront de la description qui en est donnée ci-dessous, à titre indicatif et nullement limitatif, en référence aux figures annexées, parmi lesquelles :
[Fig 1] la figure 1 représente schématiquement une première vue d'un boîtier pour composants semi-conducteurs dans un mode de réalisation;
[Fig 2] la figure 2 représente schématiquement une deuxième vue d'un boîtier pour composants semi-conducteurs dans un mode de réalisation;
[Fig 3] la figure 3 représente schématiquement une troisième vue d'un boîtier pour composants semi-conducteurs dans un mode de réalisation;
[Fig 4] la figure 4 est une représentation schématique d'un échangeur thermique microfluidique à ailettes ;
[Fig 5] la figure 5 est une représentation schématique d'un échangeur thermique microfluidique à picots ;
[Fig 6] la figure 6 représente schématiquement une première vue d'un assemblage électronique à n=4 boîtiers pour encapsulation de composants semi-conducteurs ;
[Fig 7] la figure 7 représente schématiquement une deuxième vue de l'assemblage électronique de la figure 6 ;
[Fig 8] la figure 8 représente schématiquement l'assemblage électronique de la figure 7 en vue de coupe selon la coupe B-B, et
[Fig 9] la figure 9 représente schématiquement l'assemblage électronique de la figure 7 en vue de coupe selon la coupe C-C.

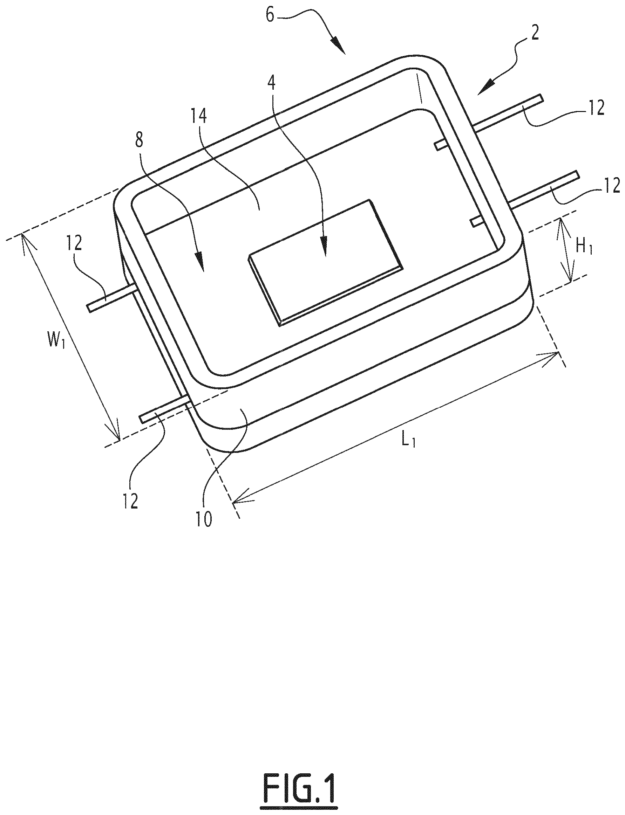

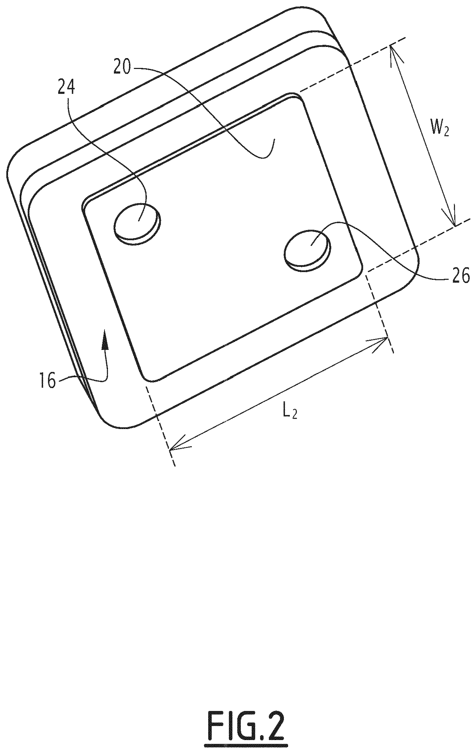

Un mode de réalisation d'un boîtier pour encapsulation de composant(s) électronique(s), par exemple à base de semi-conducteur(s), sera décrit ci-après en référence aux figures 1, 2 et 3.

Dans ces figures est représenté un boîtier 2 pour encapsulation d'un composant électronique, par exemple à base de semi-conducteur(s) 4, appelé simplement composant 4 dans la suite de la description, qui est par exemple un composant micro-électronique, appelé couramment « puce électronique ».

Un assemblage électronique 6 est réalisé par l'encapsulation du composant 4 dans le boîtier 2.

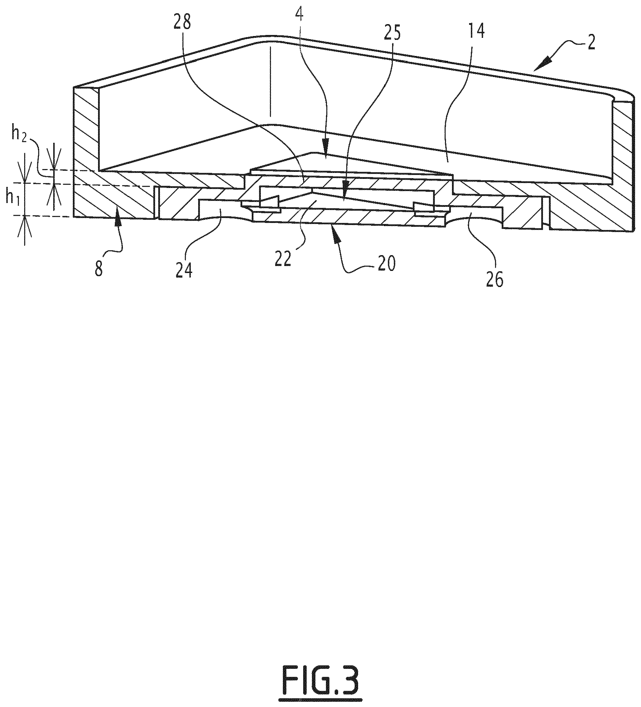

Le boitier 2 est représenté ouvert dans les figures 1 et 3, mais le boîtier comporte également un couvercle non représenté, configuré pour encapsuler le composant 4, afin de le protéger, en particulier d'assurer l'étanchéité à l'humidité.

Le boîtier 2 a une forme parallélépipédique, et comporte une première paroi de support 8, de forme rectangulaire, par exemple à bords arrondis, de dimensions respectives qui sont sa longueur L1 et sa largeur W1.

Dans un mode de réalisation, la longueur L1 et la largeur W1 sont de l'ordre de la dizaine de millimètres.

Le boîtier 2 comporte également des bords latéraux 10, de hauteur H1 de l'ordre de quelques millimètres.

Le boîtier 2 comporte également une deuxième paroi de fermeture (paroi formant couvercle), non représentée.

Les première et deuxième parois et les bords latéraux forment un espace intérieur du boîtier.

Classiquement, les première et deuxième parois et les bords latéraux sont réalisés en un premier matériau, par exemple en céramique, métal, ou en matériau composite.

Dans un mode de réalisation de l'invention, la première paroi de support est partiellement réalisée dans le premier matériau comme décrit plus en détail ci-après.

Le boîtier 2 comporte également des organes de connexion électrique 12, par exemple des « pattes » métalliques, en saillie vers l'extérieur en partant dans l'exemple de deux bords latéraux opposés.

Le nombre d'organes de connexion dépend des fonctionnalités du composant 4.

La première paroi de support 8 a une face intérieure 14, à l'intérieur du boîtier, et une face extérieure 16.

Le boîtier 2 comporte un dispositif de refroidissement micro-fluidique 20, qui est inséré dans la première paroi de support 8.

Ce dispositif de refroidissement micro-fluidique 20 comporte au moins un canal 22 de circulation d'un fluide caloporteur, faisant partie d'un échangeur thermique 25 gravé sur une surface du dispositif de refroidissement débouchant sur la face intérieure 14 de la paroi de support 8.

Les éléments constituants du dispositif de refroidissement micro-fluidiques ont des dimensions micrométriques.

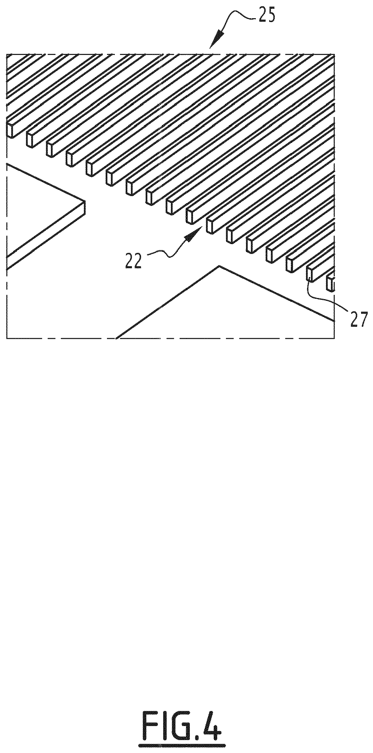

Dans un mode de réalisation illustré schématiquement à la figure 4, l'échangeur thermique 25 comporte une pluralité de canaux 22 formés par des ailettes 27 micrométriques disposées en parallèle, l'espace entre deux ailettes parallèles formant un canal.

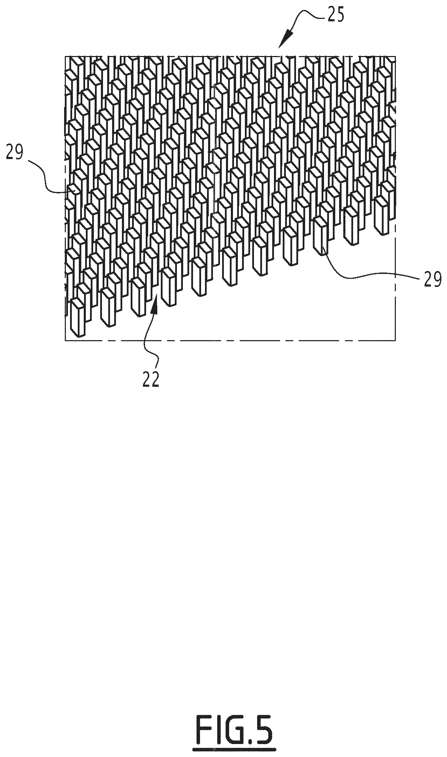

Selon une variante, illustrée schématiquement à la figure 5, l'échangeur thermique 25 comporte des picots micrométriques 29, en saillie, disposés selon un motif régulier, par exemple espacés d'une première distance selon une première direction, et espacés d'une deuxième distance selon une deuxième direction, orthogonale à la première direction. Par exemple, les picots 29 sont disposés en quinconce. Des canaux 22 de circulation du fluide caloporteur sont formés entre les picots 29.

Le fluide caloporteur est par exemple un mélange d'eau glycolée, de Coolanol^{®} ou de Poly Alpha Oléfines (PAOs).

Le dispositif de refroidissement 20 comporte un premier orifice 24 d'entrée du fluide caloporteur et à un deuxième orifice 26 de sortie du fluide caloporteur, ces orifices s'ouvrant sur la face extérieure 16 de la paroi de support 8 du boîtier 2.

Par exemple, des orifices 24, 26 sont de forme circulaire et de diamètre de l'ordre de quelques millimètres, par exemple de 2 à 4 mm.

Le dispositif de refroidissement 20 est réalisé dans un deuxième matériau, qui est de préférence du silicium.

Avantageusement, le silicium a un coefficient de dilation de l'ordre de 5µm/m.K (micromètres par mètre par Kelvin), ce qui assure une bonne compatibilité thermomécanique avec des semi-conducteurs en carbure de silicium (SiC) ou en silicium (Si).

De préférence, le dispositif de refroidissement 20 est fixé à la paroi de support 8 par brasage.

Lorsque le deuxième matériau est du silicium, un matériau de brasage est ajouté, par exemple de l'or ou un alliage d'étain-or, qui a l'avantage d'avoir une température de fusion de 280°C. Tout autre alliage métallique, de préférence présentant une température de fusion basse, est utilisable.

Selon une variante, le dispositif de refroidissement 20 est fixé à la paroi de support 8 par collage, en utilisant par exemple un mélange organique durcissant après chauffage, permettant de maintenir le contact entre le dispositif de refroidissement 20 et la paroi de support 8.

Dans le mode de réalisation illustré dans les figures 1 à 3, le dispositif de refroidissement 20 inséré dans la paroi de support.

Le dispositif de refroidissement comporte une plateforme 28 située à l'intérieur du boîtier, dans le prolongement de la face intérieure 14 de la paroi de support, sur laquelle est placé le composant 4.

Par exemple la plateforme 28 de réception du ou des composants 4 est de forme géométrique parallélépipédique, en saillie vers l'intérieur du boîtier, formant un promontoire permettant d'accueillir un composant 4.

De préférence, le composant 4 est brasé sur la plateforme 28.

Le dispositif de refroidissement a une forme sensiblement parallélépipédique, de base de longueur L2, de largeur W2, et de hauteur H2=h1+h2, h2 étant la hauteur de la plateforme 28 comme illustré à la figure 3. Par exemple, la hauteur h2 est inférieure à 1 mm.

Les dimensions de longueur et de largeur sont choisies de fonction des dimensions de longueur et de largeur du composant 4 à positionner sur le dispositif de refroidissement 20, comme montré plus clairement à la figure 3.

Avantageusement, lorsque les dimensions de la plateforme 28 sont égales ou sensiblement égales à celles du composant 4 à braser sur celle-ci, la surface d'échange thermique avec le dispositif de refroidissement est maximisée.

Le boîtier 2 ainsi réalisé comporte un dispositif de refroidissement 20 inséré dans la première paroi de support 8.

Le dispositif de refroidissement 20 inséré est mécaniquement découplé de la structure du boîtier 2.

Le boîtier 2 comporte alors une paroi de support 8 réalisée avec deux matériaux distincts, le premier matériau étant par exemple de la céramique ou du métal-céramique, et le deuxième matériau étant par exemple du silicium.

Le dispositif de refroidissement est par exemple réalisé par micro-usinage par gravure chimique.

En alternative, le dispositif de refroidissement est réalisé par une technique de fabrication additive du type frittage laser SLS (Selective Laser Sintering).

Dans le mode de réalisation décrit en référence aux figures 1 à 3, le boîtier d'encapsulation comprend une plateforme pour l'encapsulation d'un composant semi-conducteur.

En alternative non représentée, il est possible de prévoir l'insertion dans la paroi de support 8 du boîtier 2 d'un dispositif de refroidissement 20 avec deux ou plus de plateformes permettant le brasage de deux ou plus de composants semi-conducteurs.

Selon une autre variante, au moins une des dimensions de la plateforme du dispositif de refroidissement est agrandie pour accueillir plusieurs composants, l'échangeur thermique étant adapté en conséquence.

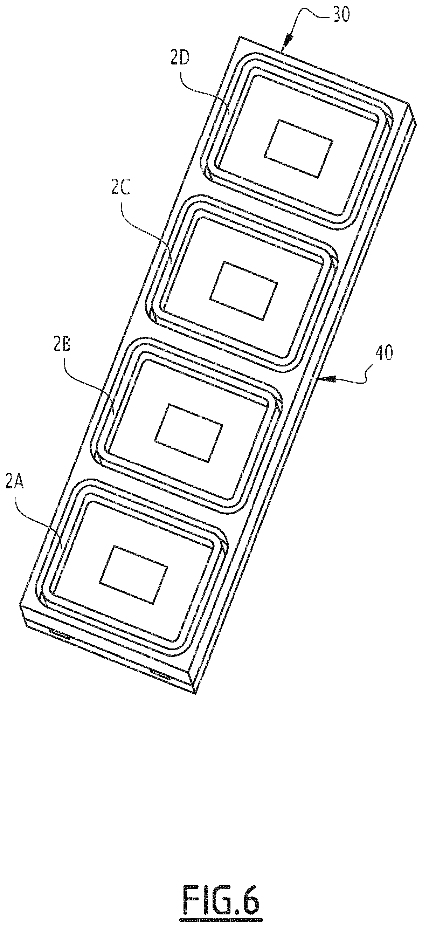

Les figures 6, 7 et 8 illustrent schématiquement un assemblage électronique de N=4 boîtier d'encapsulation de composants, par exemple à base de semi-conducteurs, monté sur un équipement (non représenté).

Bien entendu, le nombre N=4 est donné à titre d'exemple, l'invention s'appliquant de la même manière avec tout nombre N de boîtiers d'encapsulation de composants.

L'assemblage 30 comporte 4 boîtiers notés 2A,2B,2C,2D du type décrit ci-dessus, assemblés sur une structure de support 40 intégrant la distribution hydraulique (ou distribution fluidique) de fluide caloporteur.

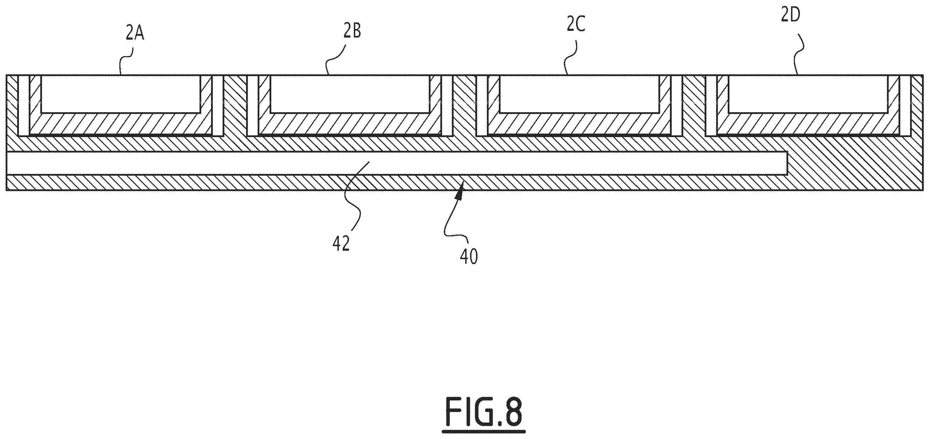

Dans la figure 8, l'assemblage 30 contentant la structure support 40 intégrant une distribution hydraulique est représenté en coupe.

Chacun des boîtier 2A, 2B, 2C, 2D est analogue au boîtier 2 décrit ci-dessus, et comporte un dispositif de refroidissement micro-fluidique, et est adapté à recevoir un ou plusieurs composants sur la plateforme dédiée du dispositif de refroidissement correspondant.

La structure de support 40 intégrant une distribution hydraulique est par exemple une pièce métallique sur laquelle sont assemblés les boîtiers, comportant une partie usinée adaptée pour distribuer le fluide caloporteur. La distribution hydraulique est réalisée par les canaux 42 et 44, dits canaux de distribution de fluide caloporteur, qui sont usinés dans l'épaisseur de la pièce 40.

La structure de support 40 est par exemple en aluminium, si la minimisation de la masse est souhaitée. En variante, la structure de support 40 est en matériaux composites.

Les canaux 42, 44 de distribution de fluide caloporteur, en connexion respectivement avec les premiers orifices d'entrée 24A, 24B, 24C, 24D et les deuxièmes orifices de sortie 26A, 26B, 26C, 26D du fluide caloporteur respectifs, permettent la circulation du fluide caloporteur dans chaque échangeur thermique de chaque boîtier. Ainsi, tous les composants 4 insérés dans les boîtiers 2A à 2D sont refroidis en même temps.

Chaque boîtier 2A, 2B, 2C, 2D comporte une face extérieure de paroi de support plane, ces faces formant une surface 46 plane.

Avantageusement, cela permet un collage de cette surface 46 sur la structure de support 40 intégrant la distribution hydraulique, par exemple en utilisant une finition dorée formant un joint local. Ce collage permet d'assurer une étanchéité entre les boîtiers et le support hydraulique.

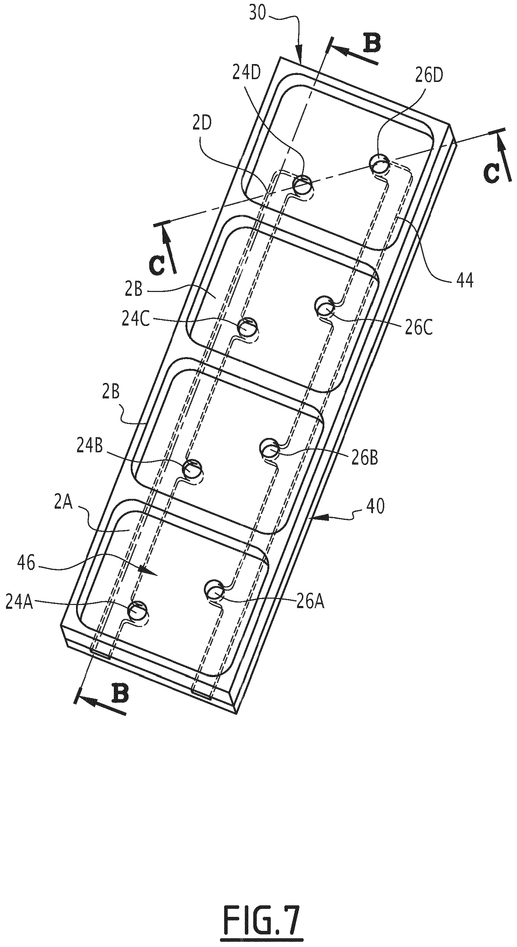

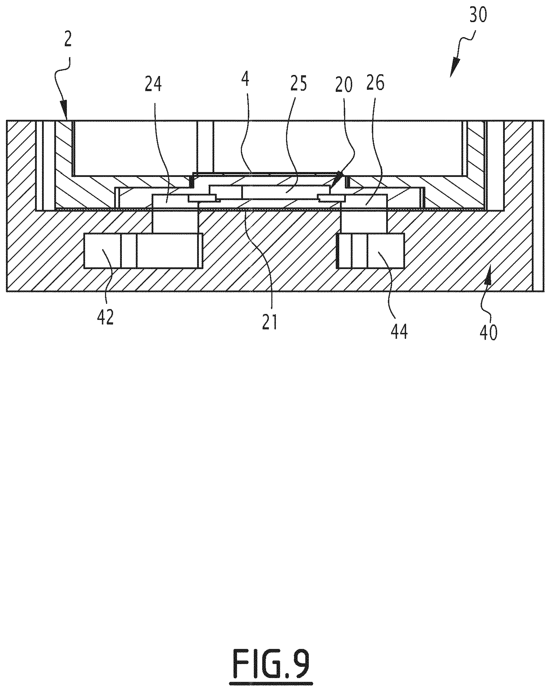

La figure 9 est une vue selon la coupe C-C (figure 7) qui illustre en coupe un des boîtiers, référencé 2 ici, encapsulant un composant 4 faisant partie de l'assemblage 30.

La coupe C-C traverse les orifices respectifs 24 et 26, comme cela est visible à la figure 7.

En plus, est visible sur la figure 9 un joint de colle 21 permettant de fixer le boîtier 2 sur la structure de support 40 intégrant la distribution hydraulique (canaux 42, 44) de fluide caloporteur.

Avantageusement, le montage d'un assemblage électronique tel que décrit ci-dessus sur un équipement est facilité.

Avantageusement, la connexion de chaque boîtier à la structure de distribution hydraulique est facilitée, aucune pièce supplémentaire n'étant nécessaire pour assurer la circulation du fluide caloporteur.

L'invention s'applique avec tout type de composant électronique, en particulier à base de semi-conducteurs, par exemple des composants en nitrure de gallium GaN, en carbure de silicium (SiC) ou en silicium.

Dans un mode de réalisation particulier, le composant électronique est un amplificateur de puissance hyperfréquence, utilisé par exemple dans des émetteurs/récepteur radar.

## Revendications

1. Boîtier pour encapsulation de composant(s) électronique(s), le boîtier formant un réceptacle destiné à recevoir au moins un composant électronique (4), comportant une première paroi de support (8) dudit au moins un composant électronique (4), des bords latéraux et une deuxième paroi de fermeture du boîtier, lesdites première et deuxième paroi et lesdits bords latéraux étant réalisés en un premier matériau, et comprenant au moins un organe de connexion électrique (12) s'étendant vers l'extérieur du boîtier (2, 2A,2B,2C,2D), ladite première paroi de support (8) comportant une face intérieure (14) adaptée à recevoir le ou les composants électroniques (4), et une face extérieure (16), le boîtier comportant un dispositif de refroidissement micro-fluidique (20) dans un deuxième matériau, inséré dans ladite première paroi de support (8), le dispositif de refroidissement micro-fluidique (20) comportant au moins un canal (22) de circulation d'un fluide caloporteur connecté à un premier orifice (24) d'entrée du fluide caloporteur et à un deuxième orifice (26) de sortie du fluide caloporteur, le dispositif de refroidissement (20) comportant au moins une plateforme (28) de réception du ou des composant(s) électroniques (4) au contact dudit au moins un canal (22) de circulation d'un fluide caloporteur.

2. Boîtier selon la revendication 1, dans lequel ledit dispositif de refroidissement (20) est fixé à ladite première paroi de support par brasage.

3. Boîtier selon l'une des revendications 1 ou 2, dans lequel le deuxième matériau dans lequel est réalisé ledit dispositif de refroidissement (20) est du silicium.

4. Boîtier selon la revendication 3, comportant un échangeur thermique (25) dans lequel est formé ledit au moins un canal (22) de circulation d'un fluide caloporteur par micro-usinage.

5. Boîtier selon la revendication 4 dans lequel ledit échangeur thermique (25) comporte des ailettes (27) disposées parallèlement, des canaux (22) de circulation d'un fluide caloporteur étant formés entre lesdites ailettes (27), ou des picots (29) disposés selon un motif régulier, des canaux de circulation (22) d'un fluide caloporteur étant formés entre lesdits picots (29).

6. Boîtier selon l'une des revendications 1 à 5, dans lequel le premier matériau est un matériau céramique ou métallique ou un matériau composite.

7. Boîtier selon l'une des revendications 1 à 6, dans lequel ladite au moins une plateforme (28) est insérée en saillie sur ladite face intérieure (14) de la première paroi de support (8), lesdits premier et deuxième orifices (24, 26) s'ouvrant vers ladite face extérieure (16) de la première paroi de support (8).

8. Boîtier selon la revendication 7 dans lequel ladite plateforme (28) a des dimensions sensiblement égales aux dimensions d'un composant électronique, ledit composant électronique étant brasé ou collé sur ladite plateforme (28).

9. Assemblage électronique comportant au moins un boîtier conforme aux revendications 1 à 8, et une structure de support (40) intégrant une distribution hydraulique (42,44) vers ledit au moins un boîtier, le ou chaque boîtier comportant un composant électronique brasé ou collé à l'intérieur du boîtier, en contact avec ledit dispositif de refroidissement (20).

10. Assemblage selon la revendication 9, dans lequel ladite structure de support (40) comporte des canaux (42, 44) de distribution de fluide caloporteur, un desdits canaux de distribution (42) de fluide caloporteur étant connecté aux premiers orifices d'entrée (24) de chaque dispositif de refroidissement (20) et un autre desdits canaux de distribution (44) de fluide caloporteur étant connecté aux deuxièmes orifices de sortie (26) de chaque dispositif de refroidissement, le ou chaque boîtier étant collé par la face extérieure (16) de la première paroi de support à ladite structure de support (40).

## Patentansprüche

1. Gehäuse zur Verkapselung elektronischer Komponenten, wobei das Gehäuse ein Behältnis zum Aufnehmen mindestens einer elektronischen Komponente (4) bildet, umfassend eine erste Trägerwand (8) der mindestens einen elektronischen Komponente (4), Seitenränder und eine zweite Wand zum Verschließen des Gehäuses, wobei die erste und zweite Wand und die Seitenränder aus einem ersten Material hergestellt sind und mindestens ein elektrisches Verbindungselement (12) umfassen, das sich von dem Gehäuse (2, 2A, 2B, 2C, 2D) nach außen erstreckt, die erste Trägerwand (8) umfassend eine Innenseite (14), die angepasst ist, um die elektronische(n) Komponente(n) (4) aufzunehmen, und eine Außenseite (16),
das Gehäuse umfassend eine mikrofluidische Kühlvorrichtung (20) aus einem zweiten Material aufweist, die in der ersten Trägerwand (8) eingesetzt ist, die mikrofluidische Kühlvorrichtung (20) umfassend mindestens einen Kanal (22) zur Zirkulation eines Wärmeträgerfluids, der mit einer ersten Einlassöffnung (24) des Wärmeträgerfluids und mit einer zweiten Auslassöffnung (26) des Wärmeträgerfluids verbunden ist, die Kühlvorrichtung (20) umfassend mindestens eine Plattform (28) zum Aufnehmen der elektronischen Komponente(n) (4), die mit dem mindestens einen Kanal (22) zur Zirkulation eines Wärmeträgerfluids in Kontakt sind.

2. Gehäuse nach Anspruch 1, wobei die Kühlvorrichtung (20) durch Hartlöten an der ersten Trägerwand befestigt ist.

3. Gehäuse nach einem der Ansprüche 1 oder 2, wobei das zweite Material, aus dem die Kühlvorrichtung (20) hergestellt ist, Silizium ist.

4. Gehäuse nach Anspruch 3, umfassend einen Wärmetauscher (25), in dem der mindestens eine Kanal (22) zur Zirkulation eines Wärmeträgerfluids durch Mikrobearbeitung gebildet ist.

5. Gehäuse nach Anspruch 4, wobei der Wärmetauscher (25) parallel angeordnete Rippen (27) umfasst, wobei zwischen den Rippen (27) Kanäle (22) für die Zirkulation eines Wärmeträgerfluids gebildet sind, oder Noppen (29), die in einem regelmäßigen Muster angeordnet sind, zwischen den Noppen (29) Zirkulationskanäle (22) für ein Wärmeträgerfluid gebildet sind.

6. Gehäuse nach einem der Ansprüche 1 bis 5, wobei das erste Material ein keramisches oder metallisches Material oder ein Verbundmaterial ist.

7. Gehäuse nach einem der Ansprüche 1 bis 6, wobei die mindestens eine Plattform (28) hervorstehend in der Innenseite (14) der ersten Trägerwand (8) eingesetzt ist, wobei sich die erste und die zweite Öffnung (24, 26) zu der Außenseite (16) der ersten Trägerwand (8) hin öffnen.

8. Gehäuse nach Anspruch 7, wobei die Plattform (28) Abmessungen aufweist, die im Wesentlichen gleich wie die Abmessungen eines elektronischen Komponente sind, wobei die elektronische Komponente auf die Plattform (28) gelötet oder geklebt ist.

9. Elektronische Anordnung, umfassend mindestens ein Gehäuse nach den Ansprüchen 1 bis 8 und eine Trägerstruktur (40), die eine hydraulische Verteilung (42, 44) zu dem mindestens einen Gehäuse integriert, wobei das oder jedes Gehäuse eine elektronische Komponente umfasst, die in das Gehäuse eingelötet oder eingeklebt ist und mit der Kühlvorrichtung (20) in Kontakt ist.

10. Anordnung nach Anspruch 9, wobei die Trägerstruktur (40) Kanäle (42, 44) zur Verteilung von Wärmeträgerfluid umfasst, einer der Verteilungskanäle (42) von Wärmeträgerfluid mit den ersten Einlassöffnungen (24) jeder Kühlvorrichtung (20) verbunden ist und ein anderer der Verteilungskanäle (44) von Wärmeträgerfluid mit den zweiten Auslassöffnungen (26) jeder Kühlvorrichtung verbunden ist, wobei das oder jedes Gehäuse durch die Außenseite (16) der ersten Trägerwand an die Trägerstruktur (40) geklebt ist.

## Claims

1. A case for packaging electronic component(s), the case forming a housing intended for receiving at least one electronic component (4), including a first support wall (8) for said at least one electronic component (4), lateral edges and a second closing wall of the case, said first and second walls and said lateral edges being made of a first material, and comprising at least one electrical connection element (12) extending towards the outside of the case (2, 2A, 2B, 2C, 2D), said first support wall (8) including an inner face (14) configured for receiving the at least one electronic component (4), and an outer face (16), the case comprising a microfluidic cooling device (20) made of a second material, inserted into said first support wall (8), the microfluidic cooling device (20) including at least one channel (22) for the circulation a heat-transfer fluid connected to a first inlet port (24) for the heat-transfer fluid and to a second outlet port (26) for the heat-transfer fluid, the cooling device (20) comprising at least one platform (28) for receiving the electronic component(s) (4) in contact with said at least one channel (22) for the circulation of a heat-transfer fluid.

2. The case according to claim 1, wherein said cooling device (20) is attached by brazing to said first support wall.

3. The case according to claim 1 or 2, wherein the second material of which said cooling device (20) is made is silicon.

4. The case according to claim 3, comprising a heat exchanger (25) wherein is formed, by micro-machining, said at least one channel (22) for the circulation of a heat-transfer fluid.

5. The case according to claim 4, wherein said heat exchanger (25) comprises fins (27) arranged in parallel, channels (22) for the circulation of a heat-transfer fluid being formed between said fins (27), or pins (29) arranged in a regular pattern, circulation channels (22) for a heat-transfer fluid being formed between said pins (29).

6. The case according to one of claims 1 to 5, wherein the first material is a ceramic or metallic material or a composite material.

7. The case according to one of claims 1 to 6, wherein said at least one platform (28) is inserted protruding from said inner face (14) of the first support wall (8), said first and second ports (24, 26) opening towards said outer face (16) of the first support wall (8).

8. The case according to claim 7, wherein said platform (28) has dimensions substantially equal to the dimensions of an electronic component, said electronic component being either brazed or bonded to said platform (28).

9. An electronic assembly comprising at least one case according to claims 1 to 8, and a support structure (40) integrating a fluid distribution (42,44) towards said at least one case, the or each case including an electronic component either brazed or bonded to the interior of the case, in contact with the cooling device (20).

10. The assembly according to claim 9, wherein said support structure (40) comprises channels (42, 44) for the distribution of heat-transfer fluid, one of said heat-transfer fluid distribution channels (42) being connected to the first inlet ports (24) of each cooling device (20) and another of said heat-transfer fluid distribution channels (44) being connected to the second outlet ports (26) of each cooling device, the or each case being bonded by the outer face (16) of the first support wall to said support structure (40).
